# EUROPÄISCHE PATENTSCHRIFT

(11) **EP 1 851 508 B1**
(45) Veröffentlichungstag und Bekanntmachung des Hinweises auf die Patenterteilung: **25.06.2008**
(21) Anmeldenummer: 06707215.7
(22) Anmeldetag: 23.02.2006
(51) Int. Cl.: G01B 11/06, C23C 14/54

(54) **OPTISCHES MONITORINGSYSTEM FÜR BESCHICHTUNGSPROZESSE**
OPTICAL MONITORING SYSTEM FOR COATING PROCESSES
SYSTEME DE SURVEILLANCE OPTIQUE POUR PROCEDES D'APPLICATION DE REVETEMENT

(30) Priorität: 26.02.2005 DE 102005008889
(43) Veröffentlichungstag der Anmeldung: 07.11.2007
(73) Patentinhaber: Leybold Optics GmbH, 63755 Alzenau (DE)
(72) Erfinder: ZÖLLER, Alfons, 63628 Bad Soden Salmünster (DE); WOLF, Hans, Dirk, 63303 Dreieich (DE); SCHMITT, Christopher, 63517 Rodenbach (DE); BOOS, Michael, 63636 Brachttal (DE); KLUG, Werner, 63579 Freigericht (DE)
(74) Vertreter: Pohlmann, Bernd Michael
(86) Internationale Anmeldenummer: PCT/EP2006/001668
(87) Internationale Veröffentlichungsnummer: WO 2006/089752

(56) Entgegenhaltungen:
- EP-A- 0 257 229
- WO-A-02/40737
- US-A- 4 878 755
- ALLAM D S ET AL: "NOTES; A piezoelectric beam chopper" 1. Dezember 1970 (1970-12-01), JOURNAL OF PHYSICS E. SCIENTIFIC INSTRUMENTS, IOP PUBLISHING, BRISTOL, GB, PAGE(S) 1022-1023 , XP020019575 ISSN: 0022-3735 das ganze Dokument

## Beschreibung

Die Erfindung betrifft ein optisches Monitoringsystem für Beschichtungsprozesse, insbesondere zur Schichtdickenmessung von auf bewegten Substraten aufgebrachten Schichten während des Beschichtungsprozesses, mit welchem Signale in zeitlich nacheinander folgenden Mess-, Referenz- und Dunkelphasen erzeugt und zur Messung der Transmission oder Reflexion von Substraten ausgewertet werden.

Bei Substraten, die zur Erzielung vorgegebener optischer Eigenschaften mit dünnen Schichten in der Größenordnung von Lichtwellenlängen beschichtet werden, müssen zur Erzielung vorgegebener Transmissions- oder Reflexionseigenschaften die Schichten mit hoher Gleichmäßigkeit und genauer Schichtdicke aufgebracht werden. Die Schichtdicke wird über Transmissions- oder Reflexionsmessungen ermittelt und erfolgt in-situ, um den Beschichtungsprozess genau zu steuern. Zur Messung derartig dünner Schichtdicken werden vielfach Fotometer verwendet, die in einer Messphase ein monochromatisches Transmissions- oder Reflexionssignal des beschichteten Substrates und ein Referenzsignal der Lichtquelle des Fotometers erfassen. Derartige Photometeranordnungen haben jedoch den Nachteil, dass die Signale von zwei unterschiedlichen Detektoren erfasst werden, deren Driften das Messergebnis beeinflusst, wobei außerdem Änderungen der Farbtemperatur der Lichtquelle nur mangelhaft berücksichtigt werden können.

Zur Beseitigung dieser Nachteile wird in der EP 0 257 229 B1 vorgeschlagen, mittels eines Choppers, der aus zwei, um eine Achse rotierenden Chopperscheiben mit sich nicht überlappenden Aussparungen von jeweils 120° besteht, zwischen denen die Lichtquelle angeordnet ist, zeitlich nacheinander eine Messphase, eine Referenzphase und eine Dunkelphase zu erzeugen. Die Erfassung der Lichtsignale in der Mess- und Referenzphase erfolgt mit einem Lichtdetektor bei der gleichen, über einen Monochromator eingestellten Wellenlänge, sodass Alterserscheinungen und Temperaturdrift von Lichtquelle und Detektor kompensiert werden können. Die Dunkelphase dient der Kompensation von Fehlern durch Fremdeinflüsse und durch Driften von elektronischen Verstärkern. Die Auswertung der Signale erfolgt mit einer Prozessoreinheit.

In der US-A-4 878 755 sind die Substrate, deren Schichtdicke zu messen ist, auf einem rotierenden Substrathalter angeordnet, dessen Drehwinkelposition von einem Inkrementalgeber ermittelt wird. Auf diesem rotierenden Substrathalter sind auch ein nicht absorbierendes Substrat zur Erzeugung einer Referenzphase und eine opake Fläche zur Erzeugung einer Dunkelphase vorgesehen. Der in den Strahlengang der Lichtquelle eingesetzte Lichtchopper dient zur Modulation des Messlichtes.

Bei der Beschichtung von kleinformatigen Substraten ist es üblich, mehrere Substrate auf rotierenden Substratträgern anzuordnen. Soll eine Schichdickenmessung während des Beschichtungsprozesses mit einer vor beschriebenen Fotometeranordnung auf dem rotierenden Substratträger erfolgen, muss eine genaue Synchronisation zwischen dem Chopperantrieb und dem Substratträgerdrehantrieb erfolgen, da sich bei unsynchronisierten Antrieben ein Zeitjitter vom Betrag der Periodendauer des Choppers ergibt, weiches zu einer unerwünschten Variation des Messortes auf dem Substrat führt.

Durch eine Synchronisation der Drehantriebe kann dieses Zeitjitter zwar reduziert, jedoch nicht vollständig eliminiert werden.

Aufgabe der Erfindung ist es daher, die Genauigkeit der Schichtdickemessung von aufgebrachten dünnen Schichten auf Substraten während des Beschichtungsprozesses weiter zu verbessern.

Die Lösung der Aufgabe gelingt mit einem optischen Monitoringsystem gemäß Anspruch 1 und mit einem Verfahren gemäß Anspruch 7.

Das erfindungsgemäße optische Monitoringsystem umfasst eine Lichtquelle, eine Lichtdetektoreinheit, eine Referenzlichtleitung, mit welcher das Licht der Lichtquelle der Lichtdetektoreinheit zugeführt wird, eine erste Messlichtleitung, mit welcher das Licht der Lichtquelle auf ein Substrat geführt wird und eine zweite Messlichtleitung, mit welcher das von dem Substrat reflektierte oder transmittierte Licht der Lichtquelle der Lichtdetektoreinheit zugeführt wird. In der Referenzlichtleitung ist ein erster piezoelektrischer oder elektrostriktiver oder magnetostriktiver Lichtchopper angeordnet und in der ersten oder zweiten Messlichtleitung ist ein zweiter piezoelektrischer oder elektrostriktiver oder magnetostriktiver Lichtchopper angeordnet. Dabei ist der erste und zweite Lichtchopper mit einer Prozessoreinheit zur Erzeugung einer Messphase, einer Referenzphase und zumindest einer Dunkelphase verbunden und ein Drehantrieb eines rotierenden Substrathalters ist zur Erfassung der Drehbewegung des auf dem Substrathalter angeordneten Substrates mit der Prozessoreinheit verbunden.

Beim erfindungsgemäßen Verfahren wird zur Schichtdickenmessung von aufgedampften oder aufgestäubten Schichten auf bewegten, insbesondere um eine Achse rotierenden, Substraten während des Beschichtungsprozesses die Lichtintensität einer Lichtquelle in einer Referenzphase, die Lichtintensität des von dem Substrat reflektierten oder transmittierten Lichts in einer Messphase und eine Restlichtintensität in zumindest einer Dunkelphase von einer Lichtdetektoreinheit erfasst, wobei die Referenzphase, die Messphase und die Dunkelphase über zumindest einen piezoelektrischen oder elektrostriktiven oder magnetostriktiven Lichtchopper zeitlich versetzt und in Abhängigkeit von der Position des Substrates digital eingestellt werden.

In einer vorteilhaften Ausführung wird in einer Referenzphase die Lichtintensität des in eine Referenzlichtleitung eingekoppelten und von einem ersten piezoelektrischen oder elektrostriktiven oder magnetostriktiven Lichtchopper freigegebenen Lichtes einer Lichtquelle von einer Lichtdetektoreinheit erfasst, in einer Messphase das Licht der Lichtquelle in eine erste Messlichtleitung eingekoppelt und das von einem zweiten piezoelektrischen oder elektrostriktiven oder magnetostriktiven Lichtchopper freigegebene Licht auf das Substrat geführt und die Lichtintensität des von dem Substrat reflektierten oder transmittierten Lichts über eine zweite. Messlichtleitung von der Lichtdetektoreinheit erfasst. Dabei verschließt der zweite Lichtchopper die erste Messlichtleitung in der Referenzphase und der erste Lichtchopper die Referenzlichtleitung in der Messphase. In zumindest einer Dunkelphase, wird außerdem eine Restlichtintensität von der Lichtdetektoreinheit erfasst, wobei der erste Lichtchopper die Referenzlichtleitung verschließt und der zweite Lichtchopper die erste Messlichtleitung verschließt. Die Referenzphase, die Messphase und die Dunkelphase werden durch die entsprechenden Einstellungen der Lichtchopper zeitlich versetzt ausgeführt und in Abhängigkeit von der Position des Substrates digital eingestellt.

Entfällt die Referenzlichtleitung und die Referenzmessung erfolgt über die Messlichtleitung, wird vorzugsweise die Referenzphase, die Messphase und die Dunkelphase über einen in der ersten oder zweiten Messlichtleitung angeordneten Lichtchopper eingestellt In diesem Fall wird der Referenzlichtweg durch zumindest eine entsprechende Aussparung eines rotierenden Substrathalters gebildet, die den Lichtweg bei Bewegung des Substrathalters freigibt. Bei einem rotierenden Substrathalter kann die Aussparung beispielsweise als freie Bohrung auf dem gleichen Radius, auf dem ein oder mehrere Substrat angeordnet sind, ausgeführt sein. Die Referenzmessung wird dann durchgeführt, wenn die freie Bohrung den Lichtstrahl kreuzt. Während der Mess- und Referenzphase gibt der Chopper den Lichtweg frei. In der Dunkelphase verschließt der Chopper den Lichtweg.

Die Einstellung der Referenz-, Mess- und Dunkelphase über piezoelektrische oder elektrostriktive oder magnetostriktive Lichtchopper ermöglicht eine direkte und sehr genaue Einstellung der einzelnen Phasen auf Grund der flexiblen, jeder Zeit verfügbaren digitalen Ansteuerbarkeit der Lichtchopper. Die Messphasen können hierbei, exakt mit dem gewünschten Messort des Substrates synchronisiert werden.

Die piezoelektrischen Lichtchopper sind piezoelektrische Aktoren, welche bei einer elektrischen Ansteuerung eine Stellbewegung ausführen. Dabei wird an einen Piezokristall ein elektrisches Feld angelegt und eine Längenänderung in Richtung der Feldstärke erzeugt. Wird die Verformung von Außen verhindert, so entsteht eine Kraft, die in Verformungsrichtung wirkt. Hierbei wird die elektrische Energie in mechanische Energie umgewandelt. Piezoelektrische Aktoren können also vereinfachend durch die Fähigkeit beschrieben werden, elektrische Spannungen in mechanische Bewegung umzuwandeln. Piezoelektrische Effekte beobachtet man bei verschiedenen kristallinen Substanzen wie beispielsweise Quarz, Natrium-Kalium-Tartrat und Ethylendiamintartrat.

Alternativ zu den piezoelektrischen Aktoren können auch elektrostriktive oder magnetostriktive Aktoren als Lichtchopper eingesetzt werden. Bei den elektrostriktiven Aktoren ändern sich die symmetrischen Kristalle in Abhängigkeit vom elektrischen Feld. Magnetostriktive Aktoren ändern ihre geometrischen Eigenschaften bei Anlegen eines äußeren magnetischen Feldes.

In einer vorteilhaften Ausführungsform der Erfindungen umfasst die Lichtdetektoreinheit ein dispersives Element, insbesondere einen Monochromator, und einen Lichtdetektor, wobei über das dispersive Element die Lichtwellenlänge des dem Lichtdetektor zugeführten Lichts einstellbar ist und spektralphotometrische Messungen möglich sind.

Zur weiteren Verarbeitung der vom Lichtdetektor detektierten Lichtintensitäten werden die am Ausgang des Lichtdetektors anliegenden Signale vorzugsweise verstärkt und mittels eines A/D-Wandlers digitalisiert. In einer Prozessoreinheit können dann die erfassten Werte durch Bildung von Differenzwerten aus Mess- und Dunkelphase sowie aus Referenz- und Dunkelphase gebildet werden. Das Verhältnis zwischen den so ermittelten Differenzwerten (Iₘₑₛₛ-I_{dunkel}/I_{ref}-I_{dunkel}) bildet ein Maß für die Reflexion oder Transmission des beschichteten Substrates. Über die Prozessoreinheit erfolgt vorzugsweise auch eine Einstellung des Verstärkers in Abhängigkeit von der jeweiligen Phase, da der Unterschied zwischen der Lichtintensität in der Messphase und Referenzphase sehr groß werden kann. Der Verstärkungsgrad ist vorzugsweise so einzustellen, dass am A/D Wandler ein möglichst großes Signal anliegt, um eine hohe Signalauflösung zu erreichen.

Weiterhin ist es vorteilhaft, wenn die Prozessoreinheit mit einem Drehantrieb eines rotierenden Substrathalters zur Erfassung der Position des auf dem Substrathalter angeordneten Substrates verbunden oder verbindbar ist. Das ist vorzugsweise über einen mit dem Drehantrieb gekoppelten Inkrementalgeber möglich, der bei jeder Umdrehung an einem definierten Drehwinkel einen Zähler auf einen definierten Wert setzt und in Abhängigkeit des Drehwinkels Pulse an den Zähler sendet. Dem Zählerstand kann damit immer ein Drehwinkel und damit die Position des Substrates zugeordnet werden. Der Zählerstand wird von der Prozessoreinheit ausgewertet und daraus Signale zur Ansteuerung der Lichtchopper zur Einstellung der Referenz-, Mess- und Dunkelphase abgeleitet.

In einer weiteren vorteilhaften Ausgestaltung der Erfindung kann die Messung der Transmission oder Reflexion während des Aufdampfprozesses kontinuierlich an stationären Substraten erfolgen. Die Einstellung der Referenz-, Mess- und Dunkelphase erfolgt dann periodisch über eine in der Prozessoreinheit integrierten Zeitsteuerung. Die Reihenfolge sowie die Zeitdauer der einzelnen Phasen kann frei gesteuert werden. Die Frequenz, mit welcher die Lichtchopper zur Einstellung der einzelnen Phasen eingestellt werden, kann dabei derart gewählt werden, dass etwaige Störfrequenzen durch Fremdlichteinflüsse der Verdampferquelle oder des Rauschens des Lichtdetektors maximal unterdrückt werden. Typische Frequenzen liegen im Bereich von 5 bis 100 Hz.

Die Erfindung soll im weiteren an Hand von Ausführungsbeispielen näher erläutert werden. Es zeigt dazu
- Fig. 1: eine schematische Darstellung eines optischen Monitoringsystems mit zwei Lichtchoppern
- Fig.2: eine schematische Darstellung eines optischen Monitoringsystems mit einem Lichtchoppern

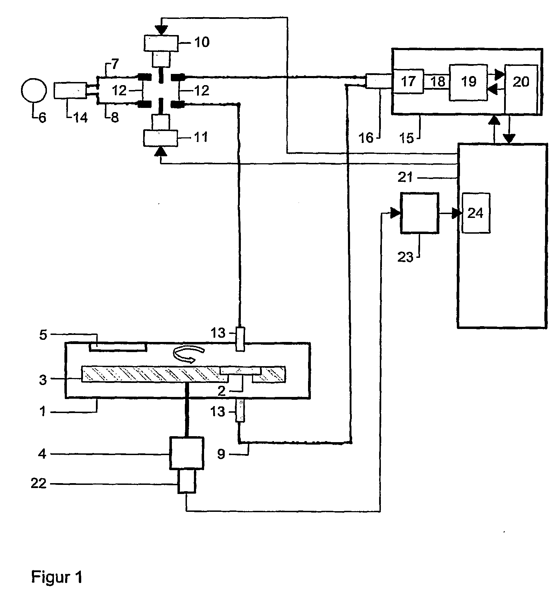

Das in Fig. 1 dargestellte optische Monitoringsystems zur Messung der Schichtdicke eines um eine Achse rotierenden Substrates während eines Beschichtungsprozesses arbeitet zur Erzeugung der Mess-, Referenz- und Dunkelphase mit zwei Lichtchoppern.

Das Substrat **2** ist in der Beschichtungskammer **1** auf einem scheibenförmigen Substrathalter **3** ca. 300 mm von der Drehachse entfernt angeordnet. Der Substrathalter **3** wird über den Drehantrieb **4** mit ca. 200 U/min bewegt und von einer oder mehreren Beschichtungsquellen **5** im Vakuum beschichtet. Das Substrat **2** ist transparent, beispielsweise ein Glas, so dass eine Schichtdickenbestimmung mit einer Transmissionsmessung erfolgen kann.

Zur Messung koppelt eine Lichtquelle **6** Licht in einen ersten Lichtleiterkoppler **14** ein. Der erste Lichtleiterkoppler **14** führt die Referenzlichtleitung **7** und die erste Messlichtleitung **8** vor der Lichtquelle **6** zusammen. In der Referenzlichtleitung **7** ist ein erster piezoelektrischer Lichtchopper **10** zwischen zwei Lichtleiterköpfen **12** der Referenzlichtleitung **7** angeordnet und in der ersten Messlichtleitung **8** ist ein zweiter piezoelektrischer Lichtchopper **11** zwischen zwei weiteren Lichtleiterköpfen **12** angeordnet. Die Lichtleiterköpfe **12** können dabei auch als optische Kollimatoren ausgeführt sein. Die Chopperfahnen des ersten und zweiten piezoelektrischen Lichtchoppers **10, 11** können mit jeweils einem piezoelektrischem Aktor unabhängig voneinander so bewegt werden, dass das Licht geblockt oder ungehindert weitergeleitet wird. Die Lichtleiterköpfe **12** sind dabei möglichst dicht an die Lichtchopperfahnen heranzuführen. Die Steuerung des "offenen" oder "geschlossenen" Zustandes der piezoelektrischen Lichtchopper **10, 11** erfolgt über die Prozessoreinheit **21.**

Am Ende der ersten Messlichtleitung **8** ist ein Lichtleiterkopf mit Kollimator **13** befestigt. Dieser ist in einer Vakuumdurchführung der Beschichtungskammer **1** so angeordnet, dass das aus der ersten Messlichtleitung **8** austretende Licht auf das Substrat **2** gelangt.

Der an der zweiten Messlichtleitung **9** befestigte Lichtleiterkopf mit Kollimator **13** ist an einem Sichtfenster der Beschichtungskammer **1** so angeordnet, dass das vom Substrat transmittierte Licht aufgenommen und der Lichtdetektoreinheit **15** zugeführt werden kann.

Das Licht der Referenzlichtleitung **7** wird ebenfalls zur Lichtdetektoreinheit **15** geführt. Vor dem Monochromator **17** der Lichtdetektoreinheit **15** werden die zweite Messlichtleitung **9** und die Referenzlichtleitung **7** in einem zweiten Lichtleitkoppler **16** zusammengeführt.

Am Austritt des Monochromators **17** ist ein Lichtdetektor **18** angebracht. Der Lichtdetektor **18** kann als Einzeldetektor, der monochromatisches Licht misst oder als Zeilendetektor, welcher Licht mehrerer Wellenlängen gleichzeitig misst, ausgeführt sein. Die Ausgangssignale des Lichtdetektors **18** werden im Verstärker **19** verstärkt und von einem A/D-Wandler **20** digitalisiert. Der Zeitpunkt der Digitalisierung wird von der Prozessoreinheit **21** vorgegeben. Die Prozessoreinheit **21** liest die digitalisierten Werte aus und verarbeitet diese weiter.

Ein Inkrementalgeber **22** ist mit der Antriebswelle des Drehantriebes **4** des Substrathalters **3** starr gekoppelt. Das Signal des Inkrementalgebers **22** wird auf einen Zähler **23** geschaltet. Der Zähler **23** erhält vom Inkrementalgeber **22** bei jeder Umdrehung an einem definierten Drehwinkel einen Nullimpuls. Der Nullimpuls setzt den Zähler **23** auf Null oder einen definierten Wert. Eine Leitung des Inkrementalgebers **22** sendet in Abhängigkeit des Drehwinkels Pulse an den Zähler **23.** Ein typischer Wert sind 2048 Pulse je Umdrehung. Der Zähler **23** wird mit den Pulsen inkrementiert oder dekrementiert. Dadurch kann dem aktuellen Zählerstand immer ein definierter Drehwinkel zugeordnet werden. Ein von der Prozessoreinheit **21** programmierter Komperator **24** wertet den Zähler aus und gibt bei vorprogrammierten Zählerstand ein Signal an die Prozessoreinheit **21.**

### Der Messablauf sieht zumindest drei Phasen vor:

### Messphase:

Die Chopperfahne des ersten piezoelektrischen Lichtchoppers **10** ist geschlossen und blockiert den Lichtdurchgang durch die Referenzlichtleitung **7.** Die Chopperfahne des zweiten piezoelektrischen Lichtchoppers **11** ist geöffnet, so dass das Licht der Lichtquelle **6** über die erste Messlichtleitung **8** zum Substrat **2** geführt wird. Das Substrat **2** wird bei jeder Umdrehung einmal beleuchtet. Das durch das Substrat transmittierte Licht wird über die zweite Messlichtleitung **9** an die Lichtdetektoreinheit **15** weitergeleitet.

Der Monochromator **17** ist im einfachsten Fall ein Linienfilter mit nur einer Durchlasswellenlänge. Es ist jedoch vorteilhaft, einen Gittermonochromator mit einstellbarer Wellenlänge zu verwenden. Dadurch kann in Abhängigkeit der Schichtdicke eine vorteilhafte Wellenlänge gewählt werden. Die Wellenlänge des Monochromators **17** wird vor Beginn der Beschichtung auf den gewünschten Wert eingestellt.

Anstatt eines Monochromators **17** kann auch ein sogenannter Polychromator mit Zeilendetektor verwendet werden. Dabei wird eine Dioden- oder CCD Zeile von einem optischen Gitter beleuchtet. Jedes Einzelelement wird mit einer anderen Wellenlänge beleuchtet. Damit ist ein ganzen Wellenlängenspektrum simultan messbar.

Beginn und Ende der Messzeit sind durch den Komperator **24** für den A/D-Wandier **20** so eingestellt, dass die Messung erfolgt, während sich das Substrat **2** im Strahlengang befindet. Am Ende der Messzeit wird der digitalisierte Wert der Messung von der Prozessoreinheit **21** ausgelesen.

### Referenzphase:

Die Chopperfahne des zweiten piezoelektrischen Lichtchoppers **12** ist geschlossen und blockiert den Lichtdurchgang durch die erste Messlichtleitung **8.** Die Chopperfahne des ersten piezoelektrischen Lichtchoppers **11** ist geöffnet, so dass das Licht der Lichtquelle **6** über die Referenzlichtleitung **7** an die Lichtdetektoreinheit **15** weitergeleitet wird. Die Monochromatoreinstellung ist gegenüber der Messphase unverändert. Beginn und Ende der Messzeit sind dabei unabhängig von der Winkelposition des Substrates **2,** werden allerdings ebenfalls über den Zähler **23** und Komperator **24** definiert. Sinnvollerweise erfolgt die Referenzmessung unmittelbar vor oder nach einer Messphase. Am Ende der Messzeit wird der digitalisierte Wert der Messung von der Prozessoreinheit **21** ausgelesen.

### Dunkelphase:

Die Chopperfahne des ersten und des zweiten piezoelektrischen Lichtchoppers **10, 11** ist geschlossen. Beginn und Ende der Messzeit sind ebenfalls unabhängig von der Winkelposition des Substrates **2** und werden über den Zähler **23** und Komperator **24** definiert. Sinnvollerweise erfolgt die Dunkelmessung unmittelbar vor oder nach einer Messphase und/oder einer Referenzphase. Am Ende der Messzeit wird der digitalisierte Wert der Messung von der Prozessoreinheit **21** ausgelesen.

### Nach Abschluss der Phasen werden die Messwerte folgendermaßen verrechnet:

Die Differenzwerte der Lichtintensitäten aus Mess- und Dunkelphase sowie aus Referenz- und Dunkelphase werden ins Verhältnis gesetzt (Iₘₑₛₛ-I_{dunkel}/I_{ref}-I_{dunkel}). Damit steht ein Messwert zur Verfügung, welcher proportional zur Lichttransmission des Substrates **2** ist. Schwankungen der Lichtquelle **6** und der Detektorempfindlichkeit wurden kompensiert.

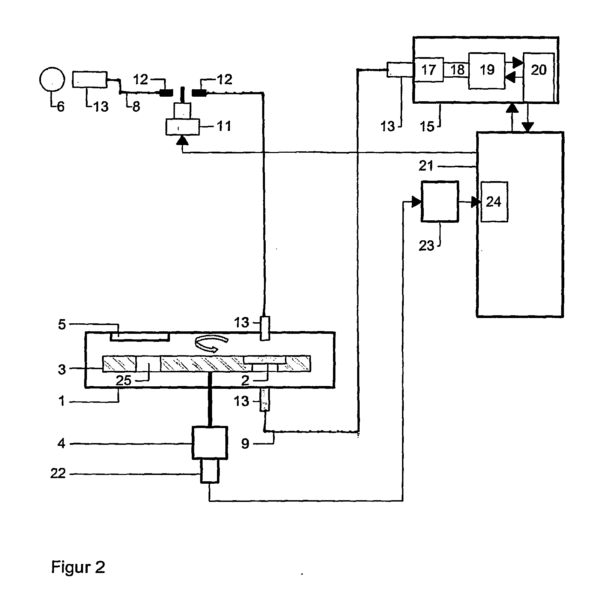

Das in Fig. 2 dargestellte optische Monitoringsystems zur Messung der Schichtdicke eines um eine Achse rotierenden Substrates während eines Beschichtungsprozesses arbeitet zur Erzeugung der Mess-, Referenz- und Dunkelphase mit nur einem Lichtchopper.

Der Substrathalter **3** weist hierbei zur Bildung eines Referenzlichtweges eine auf dem gleichen Radius wie das Substrat **2** angeordnete Aussparung **25** auf.

Zur Messung koppelt eine Lichtquelle **6** Licht über einen Lichtleiterkopf mit Kollimator **13** in die erste Messlichtleitung **8.** In der ersten Messlichtleitung **8** ist ein piezoelektrischer Lichtchopper **11** zwischen zwei weiteren Lichtleiterköpfen **12** angeordnet. Die Lichtleiterköpfe **12** können dabei auch als optische Kollimatoren ausgeführt sein. Die Chopperfahne des piezoelektrischen Lichtchoppers **11** kann mit einem piezoelektrischem Aktor so bewegt werden, dass das Licht geblockt oder ungehindert weitergeleitet wird. Die Steuerung des "offenen" oder "geschlossenen" Zustandes des piezoelektrischen Lichtchoppers **11** erfolgt über die Prozessoreinheit **21.**

Am Ende der ersten Messlichtleitung **8** ist ein Lichtleiterkopf mit Kollimator **13** befestigt. Dieser ist in einer Vakuumdurchführung der Beschichtungskammer **1** so angeordnet, dass das aus der ersten Messlichtleitung **8** austretende Licht auf das Substrat **2** oder durch die Aussparung **25** gelangt.

Der an der zweiten Messlichtleitung **9** befestigte Lichtleiterkopf mit Kollimator **13** ist an einem Sichtfenster der Beschichtungskammer **1** so angeordnet, dass das vom Substrat **2** transmittierte Licht als Messlicht oder das durch die Aussparung **25** durchgelassene Licht als Referenzlicht aufgenommen und der Lichtdetektoreinheit **15** zugeführt werden kann.

Am Austritt des Monochromators **17** ist ein Lichtdetektor **18** angebracht. Die Ausgangssignale des Lichtdetektors **18** werden im Verstärker **19** verstärkt und von einem A/D-Wandler **20** digitalisiert. Der Zeitpunkt der Digitalisierung wird von der Prozessoreinheit **21** vorgegeben. Die Prozessoreinheit **21** liest die digitalisierten Werte aus und verarbeitet diese weiter.

Ein Inkrementalgeber **22** ist mit der Antriebswelle des Drehantriebes **4** des Substrathalters **3** starr gekoppelt. Das Signal des Inkrementalgebers **22** wird analog zum oben stehende Ausführungsbeispiel, auf einen Zähler **23** geschaltet und von der Prozessoreinheit **21** ausgewertet.

### Der Messablauf sieht zumindest drei Phasen vor:

### Messphase:

Die Chopperfahne des piezoelektrischen Lichtchoppers **11** ist geöffnet, so dass das Licht der Lichtquelle **6** über die erste Messlichtleitung **8** zum Substrat **2** geführt wird. Das Substrat **2** wird bei jeder Umdrehung einmal beleuchtet. Das durch das Substrat transmittierte Licht wird über die zweite Messlichtleitung **9** an die Lichtdetektoreinheit **15** weitergeleitet.

Beginn und Ende der Messzeit sind durch den Komperator **24** für den A/D-Wandier **20** so eingestellt, dass die Messung erfolgt, während sich das Substrat **2** im Strahlengang befindet. Am Ende der Messzeit wird der digitalisierte Wert der Messung von der Prozessoreinheit **21** ausgelesen.

### Referenzphase:

Die Chopperfahne des piezoelektrischen Lichtchoppers **12** ist geöffnet, so dass das Licht der Lichtquelle **6** durch die Aussparung **25** an die Lichtdetektoreinheit **15** weitergeleitet wird. Die Monochromatoreinstellung ist gegenüber der Messphase unverändert.

Beginn und Ende der Messzeit sind durch den Komperator **24** für den A/D-Wandler **20** so eingestellt, dass die Messung erfolgt, während sich die Aussparung **25** im Strahlengang befindet. Am Ende der Messzeit wird der digitalisierte Wert der Messung von der Prozessoreinheit **21** ausgelesen.

### Dunkelphase:

Die Chopperfahne des piezoelektrischen Lichtchoppers **11** ist geschlossen. Beginn und Ende der Messzeit sind unabhängig von der Winkelposition des Substrates **2** und werden über den Zähler **23** und Komperator **24** definiert. Sinnvollerweise erfolgt die Dunkelmessung unmittelbar vor oder nach einer Messphase und/oder einer Referenzphase. Am Ende der Messzeit wird der digitalisierte Wert der Messung von der Prozessoreinheit **21** ausgelesen.

Um Einflüsse von Fremdlichtquellen zu eliminieren, ist es sinnvoll, eine Dunkelmessung dann vorzunehmen, wenn das Substrat **2** sich noch im Strahlengang befindet. Das Fremdlicht wird dann sowohl in der Messphase als auch in der Dunkelphase gemessen und kann in der anschließenden Auswertung durch Differenzbildung herausgerechnet werden.

### Nach Abschluss der Phasen werden die Messwerte folgendermaßen verrechnet:

Die Differenzwerte der Lichtintensitäten aus Mess- und Dunkelphase sowie aus Referenz- und Dunkelphase werden ins Verhältnis gesetzt (Iₘₑₛₛ-I_{dunkel}/I_{ref}-I_{dunkel}). Damit steht ein Messwert zur Verfügung, welcher proportional zur Lichttransmission des Substrates **2** ist. Schwankungen der Lichtquelle **6** und der Detektorempfindlichkeit wurden kompensiert.

### BEZUGSZEICHENLISTE

- 1: Beschichtungskammer
- 2: Substrat
- 3: Substrathalter
- 4: Drehantrieb
- 5: Beschichtungsquelle
- 6: Lichtquelle
- 7: Referenzlichtleitung
- 8: erste Messlichtleitung
- 9: zweite Messlichtleitung
- 10: erster piezoelektrischer Lichtchopper
- 11: zweiter piezoelektrischer Lichtchopper
- 12: Lichtleiterkopf
- 13: Lichtleiterkopf mit Kollimator
- 14: erster Lichtleiterkoppler
- 15: Lichtdetektoreinheit
- 16: zweiter Lichtleitetkoppler
- 17: Monochromator
- 18: Lichtdetektor
- 19: Verstärker
- 20: A/D-Wandler
- 21: Prozessoreinheit
- 22: Inkrementalgeber
- 23: Zähler
- 24: Komperator
- 25: Aussparung

## Patentansprüche

1. Optisches Monitoringsystem, insbesondere zur Schichtdickenmessung von auf Substrate (2) während des Beschichtungsprozesses aufgebrachten Schichten, zumindest umfassend
eine Lichtquelle (6),
eine Lichtdetektoreinheit (15),
eine Referenzlichtleitung (7), mit welcher das Licht der Lichtquelle (6) der Lichtdetektoreinheit (15) zugeführt wird;
eine erste Messlichtleitung (8), mit welcher das Licht der Lichtquelle (6) auf ein Substrat (2) geführt wird,
eine zweite Messlichtleitung (9), mit welcher das von dem Substrat (2) reflektierte oder transmittierte Licht der Lichtdetektoreinheit (15) zugeführt wird,
einen in der Referenzlichtleitung (7) angeordneten ersten piezoelektrischen oder elektrostriktiven oder magnetostriktiven Lichtchopper (10) und
einen in der ersten Messlichtleitung (8) oder zweiten Messlichtleitung (9) angeordneten zweiten piezoelektrischen oder elektrostriktiven oder magnetostriktiven Lichtchopper (11), wobei der erste und zweite Lichtchopper (10, 11) mit einer Prozessoreinheit (21) zur Erzeugung einer Messphase, einer Referenzphase und zumindest einer Dunkelphase verbunden ist und ein Drehantrieb (4) eines rotierenden Substrathalters (3) zur Erfassung der Drehbewegung des auf dem Substrathalter (3) angeordneten Substrates (2) mit der Prozessoreinheit (21) verbunden ist.

2. Optisches Monitoringsystem nach Anspruch 1, bei dem
die Lichtdetektoreinheit (15) ein dispersives Element und einen Lichtdetektor (18) umfasst, wobei über das dispersive Element die Lichtwellenlänge des dem Lichtdetektor (18) zugeführten Lichts einstellbar ist.

3. Optisches Monitoringsystem nach Anspruch 2, wobei
das dispersive Element ein Monochromator (17) ist.

4. Optisches Monitoringsystem nach einem der vorhergehenden Ansprüche, bei dem
die Lichtdetektoreinheit (15) einen Signalverstärker (19) und A/D-Wandler (20) aufweist.

5. Optisches Monitoringsystem nach einem der vorhergehenden Ansprüche, wobei
die Lichtdetektoreinheit (15) mit der Prozessoreinheit (21) verbunden ist.

6. Optisches Monitoringsystem nach einem der vorhergehenden Ansprüche, wobei
der Drehantrieb (4) über einen Inkrementalgeber (22) und Zähler (23) mit der Prozessoreinheit (21) verbunden ist.

7. Verfahren zur Schichtdickenmessung von aufgedampften oder aufgestäubten Schichten auf bewegten, insbesondere um eine Achse rotierenden, Substraten während des Beschichtungsprozesses, bei welchem
- die Lichtintensität einer Lichtquelle in einer Referenzphase von einer Lichtdetektoreinheit erfasst wird;
- die Lichtintensität des von dem Substrat reflektierten oder transmittierten Lichts in einer Messphase von der Lichtdetektoreinheit erfasst wird,
- eine Restlichtintensität - in zumindest einer Dunkelphase von der Lichtdetektoreinheit erfasst wird,
**dadurch gekennzeichnet, dass** die Referenzphase, die Messphase und die Dunkelphase über zumindest einen piezoelektrischen oder elektrostriktiven oder magnetostriktiven Lichtchopper zeitlich versetzt und in Abhängigkeit von der Position des Substrates digital eingestellt werden.

8. Verfahren nach Anspruch 7, **dadurch gekennzeichnet, dass** die Referenzphase, die Messphase und die Dunkelphase über einen in einem Referenzlichtweg angeordneten und einen im Messlichtweg angeordneten Lichtchopper eingestellt werden.

9. Verfahren nach Anspruch 8, **dadurch gekennzeichnet, dass** die Position des Substrates über einen Inkrementalgeber und Zähler erfasst wird, wobei jedem Wert des Zählers eine Winkelposition des Substrates zugeordnet wird.

## Claims

1. Optical monitoring system, in particular for layer thickness measurement of layers applied to substrates (2) during the coating process, at least comprising
a light source (6),
a light detector unit (15),
a reference light line (7), by which the light from the light source (6) is fed to the light detector unit (15);
a first measurement light line (8), by which the light from the light source (6) is guided onto a substrate (2),
a second measurement light line (9), by which the light transmitted or reflected by the substrate (2) is fed to the light detector unit (15),
a first piezoelectric or electrostrictive or magnetostrictive light chopper (10) arranged in the reference light line (7), and
a second piezoelectric or electrostrictive or magnetostrictive light chopper (11) arranged in the first measurement light line (8) or second measurement light line (9), wherein the first and second light choppers (10, 11) are connected to a processor unit (21) for generating a measurement phase, a reference phase and at least one dark phase, and a rotary drive (4) of a rotating substrate holder (3), for detecting the rotary movement of the substrate (2) arranged on the substrate holder (3), is connected to the processor unit (21).

2. Optical monitoring system according to Claim 1, in which the light detector unit (15) comprises a dispersive element and a light detector (18), wherein the light wavelength of the light fed to the light detector (18) can be set by means of the dispersive element.

3. Optical monitoring system according to Claim 2, wherein the dispersive element is a monochromator (17).

4. Optical monitoring system according to any of the preceding claims, in which the light detector unit (15) has a signal amplifier (19) and an A/D converter (20).

5. Optical monitoring system according to any of the preceding claims, wherein the light detector unit (15) is connected to the processor unit (21).

6. Optical monitoring system according to any of the preceding claims, wherein the rotary drive (4) is connected to the processor unit (21) via an incremental encoder (22) and counter (23).

7. Method for layer thickness measurement of layers applied by vapour deposition or sputtering on substrates that are moved, in particular rotate about an axis, during the coating process, in which
- the light intensity of a light source is detected by a light detector unit in a reference phase;
- the light intensity of the light transmitted or reflected by the substrate is detected by the light detector unit in a measurement phase,
- a residual light intensity is detected by the light detector unit in at least one dark phase,
**characterized in that** the reference phase, the measurement phase and the dark phase are temporally offset by means of at least one piezoelectric or electrostrictive or magnetostrictive light chopper and are set digitally depending on the position of the substrate.

8. Method according to Claim 7, **characterized in that** the reference phase, the measurement phase and the dark phase are set by means of a light chopper arranged in a reference light path and a light chopper arranged in the measurement light path.

9. Method according to Claim 8, **characterized in that** the position of the substrate is detected by means of an incremental encoder and counter, wherein an angular position of the substrate is assigned to each value of the counter.

## Revendications

1. Système de surveillance optique, notamment pour la mesure de l'épaisseur de couches appliquées sur des substrats (2) pendant le processus de revêtement, comprenant au moins
une source de lumière (6),
une unité de détection de lumière (15),
une ligne de lumière de référence (7) avec laquelle la lumière de la source de lumière (6) est acheminée à l'unité de détection de lumière (15),
une première ligne de lumière de mesure (8) avec laquelle la lumière de la source de lumière (6) est acheminée sur un substrat (2),
une deuxième ligne de lumière de mesure (9) avec laquelle la lumière réfléchie ou transmise par le substrat (2) est acheminée à l'unité de détection de lumière (15),
un vibrateur de lumière (10) piézoélectrique, électrostrictif ou magnétostrictif disposé dans la ligne de lumière de référence (7) et
un deuxième vibrateur de lumière (11) piézoélectrique, électrostrictif ou magnétostrictif disposé dans la première ligne de lumière de mesure (8) ou dans la deuxième ligne de lumière de mesure (9), le premier et le deuxième vibrateur de lumière (10, 11) étant reliés avec une unité à processeur (21) pour générer une phase de mesure, une phase de référence et au moins une phase sombre et un mécanisme d'entraînement de rotation (4) d'un porte-substrat (3) rotatif étant relié avec l'unité à processeur (21) pour détecter le mouvement de rotation du substrat (2) disposé sur le porte-substrat (3).

2. Système de surveillance optique selon la revendication 1, avec lequel l'unité de détection de lumière (15) comprend un élément dispersif et un détecteur de lumière (18), la longueur d'onde de la lumière acheminée au détecteur de lumière (18) pouvant être réglée par le biais de l'élément dispersif.

3. Système de surveillance optique selon la revendication 2, l'élément dispersif étant un monochromateur (17).

4. Système de surveillance optique selon l'une des revendications précédentes, avec lequel l'unité de détection de lumière (15) présente un amplificateur de signal (19) et un convertisseur A/N (20).

5. Système de surveillance optique selon l'une des revendications précédentes, l'unité de détection de lumière (15) étant reliée avec l'unité à processeur (21).

6. Système de surveillance optique selon l'une des revendications précédentes, le mécanisme d'entraînement de rotation (4) étant relié avec l'unité à processeur (21) par le biais d'un codeur incrémental (22) et d'un compteur (23).

7. Procédé de surveillance optique de couches appliquées par vaporisation ou par pulvérisation pendant le processus de revêtement sur des substrats mobiles, notamment en rotation autour d'un axe, avec lequel
- l'intensité lumineuse d'une source de lumière dans une phase de référence est détectée par une unité de détection de lumière ;
- l'intensité lumineuse de la lumière réfléchie ou transmise par le substrat est détectée par l'unité de détection de lumière dans une phase de mesure ;
- une intensité lumineuse résiduelle est détectée par l'unité de détection de lumière dans au moins une phase sombre, **caractérisé en ce que**
la phase de référence, la phase de mesure et la phase sombre sont décalées dans le temps par le biais d'au moins un vibrateur de lumière piézoélectrique, électrostrictif ou magnétostrictif et étant réglées de manière numérique en fonction de la position du substrat.

8. Procédé selon la revendication 7, **caractérisé en ce que** la phase de référence, la phase de mesure et la phase sombre sont réglées par le biais d'un vibrateur de lumière disposé dans un trajet de lumière de référence et d'un vibrateur de lumière disposé dans un trajet de lumière de mesure.

9. Procédé selon la revendication 8, **caractérisé en ce que** la position du substrat est détectée par le biais d'un codeur incrémental et d'un compteur, une position angulaire du substrat étant associée à chaque valeur du compteur.
